# EUROPÄISCHE PATENTSCHRIFT

(11) **EP 0 529 119 B1**
(45) Veröffentlichungstag und Bekanntmachung des Hinweises auf die Patenterteilung: **24.04.1996**
(21) Anmeldenummer: 91114232.1
(22) Anmeldetag: 24.08.1991
(51) Int. Cl.: H03G 3/00, H03G 9/02

(54) **Monolithisch integrierter Differenzverstärker mit digitaler Verstärkungseinstellung**
Monolithic integrated amplifier with digital gain control
Amplificateur intégré monolithique avec commande de gain

(43) Veröffentlichungstag der Anmeldung: 03.03.1993
(73) Patentinhaber: Deutsche ITT Industries GmbH, D-79108 Freiburg (DE)
(72) Erfinder: Theus, Ulrich, Dr.-Ing., W-7803 Gundelfingen (DE)

(56) Entgegenhaltungen:
- US-A- 4 064 506
- PATENT ABSTRACTS OF JAPAN vol. 10, no. 95 (E-395)(2152) 12. April 1986
- EDN ELECTRICAL DESIGN NEWS. Bd. 32, Nr. 2, 22. Januar 1987, NEWTON, MASSACHUSETTS US Seiten 181 - 187; A. KANIEL: 'Flexible PGA designs require few components.'

## Beschreibung

Die Erfindung betrifft einen monolithisch integrierten Differenzverstärker mit digitaler Verstärkungseinstellung, vgl. den Wortlaut des Anspruchs 1. Monolitisch integrierte Schaltungen mit digitaler Verstärkungseinstellung werden in digital gesteuerten Regelstufen für analoge Signale verwendet. Eine Verstärkungsregelung ist dabei insbesondere dann erforderlich, wenn das analoge Signal mittels eines Analog/Digital-Umsetzers digitalisiert werden soll und das analoge Signal in seiner Amplitude sehr unterschiedlich ist. Ohne Verstärkungsregelung würde sich die digitale Signalauflösung bei kleinen Amplituden sehr verschlechtern.

Der Vorteil der Digitalisierung kommt auch der Amplituden-Regelschaltung zugute, wenn die Regelschaltung als Digitalschaltung realisiert ist. Die eigentliche Regelstrecke ist dann der analog arbeitende Differenzverstärker mit digitaler Verstärkungseinstellung gemäß der Erfindung.

In "IEEE Journal of Solid-State Circuits", Bd.SC-22, Nr. 6, Dezember 1987, Seiten 1082 bis 1089 ist unter dem Titel: "A Programmable Gain/Loss Circuit" ausführlich eine monolithisch integrierte Schaltung beschrieben, die über einen Dateneingang in der Verstärkung oder Dämpfung umgeschaltet werden kann. Die in CMOS-Technik realisierte Schaltung enthält dabei einen Operationsverstärker und ein ohmsches Rückkopplungsnetzwerk aus einer Widerstandskette, dessen Abgriffe einzeln über einen 1-aus-n-Schalter (= Multiplexer) mit dem invertierenden Verstärkereingang verbunden werden können. Entsprechend dem jeweiligen Abgriffspunkt ändert sich das Verhältnis von Eingangswiderstand zu Rückkopplungswiderstand und damit die eingestellte Verstärkung.

Ein Differenzverstärker mit einer gesteuerten Verstärkungseinstellung ist aus Patent Abstracts of Japan, vol. 10, no. 95 (E-395)(2152), 12. April 1986 (&JP-A-60 236 509) bekannt. Dort sind zwei schaltbare Widerstandsketten mit Abgriffen den invertierenden bzw. nichtinvertierenden Eingängen des Differenzverstärkers vorgeschaltet, wobei über die schaltbaren Widerstände eine Verstärkungseinstellung ermöglicht wird. Die Eingänge der Widerstandsketten bilden die Eingänge der Verstärkerschaltung, der Ausgang der einen Kette ist mit dem Ausgang des Verstärkers verbunden und der Ausgang der anderen Kette liegt auf einem Bezugspotential. Die Abgriffe zwischen den Widerständen sind über Schalter jeweils mit dem invertierenden bzw. nichtinvertierenden Eingang des Differenzverstärkers verbindbar.

Ein Nachteil dieser beschriebenen Anordnungen besteht darin, daß das Verstärkungs-Bandbreite-Produkt durch den Operationsverstärker festlegt ist, und zwar in der Regel für den ungünstigsten Fall der vollen Gegenkopplung. Dies verschlechtert für alle anderen Verstärkungen die Bandbreite. Je höher die eingestellte Verstärkung gewählt wird, desto geringer ist die erreichbare Bandbreite.

Die Aufgabe der Erfindung besteht darin, eine monolithisch integrierte Schaltungsanordnung anzugeben, die über einen großen Verstärkungs-Einstellungsbereich verfügt und den Nachteil der Bandbreitenbegrenzung durch ein fest vorgegebenes Verstärkungs-Bandbreite-Produkt nicht aufweist.

Die Lösung der Aufgabe erfolgt durch die in den Ansprüchen gekennzeichneten Erfindung.

Der Grundgedanke der Erfindung besteht darin, das Verstärkungs-Bandbreite-Produkt des Operationsverstärkers in Stufen umschaltbar zu machen, wobei das jeweilige Verstärkungs-Bandbreite-Produkt an die eingestellte Verstärkung angepaßt wird. Die Anpassung erfolgt durch eine einfache digitale Zuordnung der Verstärkungs-Bandbreite-Produkt-Einstellung zu einzelnen Verstärkungsbereichen, die durch das digitale Steuersignal für den Multiplexer definiert sind. Die Verstärkungs-Bandbreite-Produkt-Einstellung kann dabei wesentlich grober sein als die feinstufige Verstärkungseinstellung.

Die Erfindung und weitere Vorteile werden nun anhand der Figuren der Zeichnung näher erläutert:

Fig. 1 zeigt schematisch als Blockschaltbild den digital einstellbaren Differenzverstärker nach der Erfindung,

Fig. 2 zeigt den einstellbaren Frequenzgang des adaptiven Verstärkers und

Fig. 3 zeigt einen Schaltungsausschnitt des adaptiven Verstärkers in CMOS-Technik.

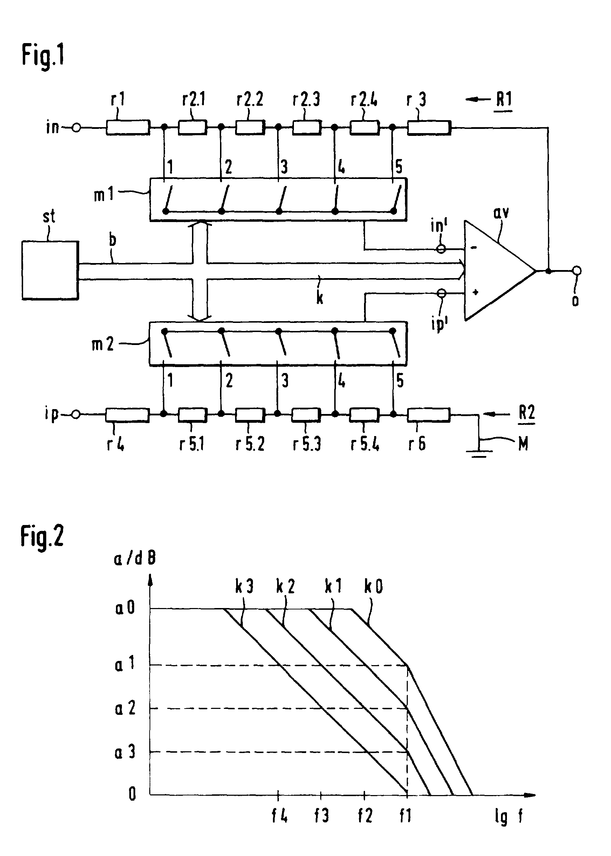

Die Konfiguration des Blockschaltbildes nach Fig. 1 unterscheidet sich gegenüber dem Stand der Technik darin, daß die Datensignale eines Datenbusses b nicht nur 1-aus-n-Schaltern (= erster und zweiter Multiplexer) m1, m2 zugeführt sind, sondern auch einem Dateneingang eines adaptiven Verstärkers av. An dessen Ausgangsklemme o ist eine erste Widerstandskette R1 angeschlossen, deren anderes Ende den invertierenden Eingang in bildet. Eine zweite Widerstandskette R2 mit Abgriffen ist an einem Ende mit dem nichtinvertierenden Eingang ip und am anderen Ende mit einem festen Bezugspotential M verbunden.

Die Abgriffe zwischen den einzelnen Widerstandselementen r1, r2.1, r2.2, ..., r3 sind jeweils mit einem Eingang 1, ..., 5 des ersten Multiplexers m1 verbunden. Entsprechend sind die Abgriffe der zweiten Widerstandskette zwischen den Widerstandselementen r4, r5.1, r5.2, ..., r6 mit jeweils einem Eingang 1, ..., 5 des zweiten Multiplexers m2 verbunden. Der Ausgang des ersten bzw. zweiten Multiplexers ist an den invertierenden bzw. nichtinvertierenden Eingang in', ip' des adaptiven Verstärkers av angeschlossen.

Eine Steuereinrichtung st, die beispielsweise Teil einer nicht dargestellten digitalen Amplitudenregelschaltung ist, speist den Datenbus b mit einem Datensignal, das die beiden Multiplexer entsprechend der gewünschten Verstärkung umschaltet. Im dargestellten Beispiel wird die Schaltposition 4 durchgeschaltet, während alle anderen Schalter geöffnet sind. Somit liegt der Abgriff zwischen dem Widerstandselement r2.3 und r2.4 am invertierenden Eingang in' und der Abgriff zwischen dem Widerstandselement r5.3 und r5.4 am nichtinvertierenden Eingang ip'. Damit ist das Verhältnis von Rückkopplungswiderstand zu Eingangwiderstand in den beiden Signalzweigen festgelegt, und damit auch die Verstärkung.

Mit den Daten auf dem Datenbus b werden dem adaptiven Verstärker av auch diejenigen Steuersignale k zugeführt, die zur internen Umschaltung des Verstärkungs-Bandbreiten-Produkts erforderlich sind.

Die unterschiedlichen Frequenzgangkurven des adaptiven Verstärkers av sind in doppellogarithmischer Darstellung schematisch in Fig. 2 wiedergegeben. Die horizontale Achse zeigt die Frequenz (=f) und die vertikale Achse die Verstärkung (=a). Die Kurve k3 zeigt den 20 dB/Dekade Verstärkungsabfall bei vollständiger Frequenzkompensation. Mit zunehmender Verstärkung sinkt die Bandbreite ab. Bei voller Gegenkopplung a = 0 dB wird die Frequenz f1 erreicht, bei der Verstärkung a1 sinkt die Bandbreite auf den Frequenzwert f4 ab. Die Frequenzgangkurve k2 zeigt den adaptiven Verstärker av mit einem vergrößerten Verstärkungs-Bandbreite-Produkt. Hierbei wird die verfügbare Bandbreite bei der Verstärkung a1, a2 und a3 vergrößert. Eine volle Gegenkopplung ist nicht mehr möglich, weil in diesem Frequenzbereich die dargestellte Frequenzabsenkung größer als 20 dB/Dekade ist.

Für die Frequenzgangkurve k1 und k0 ist die erreichbare Bandbreite noch größer, allerdings darf bei der Frequenzgangkurve k1 bzw. k0 die eingestellte Verstärkung nicht kleiner als a2 bzw. a1 sein.

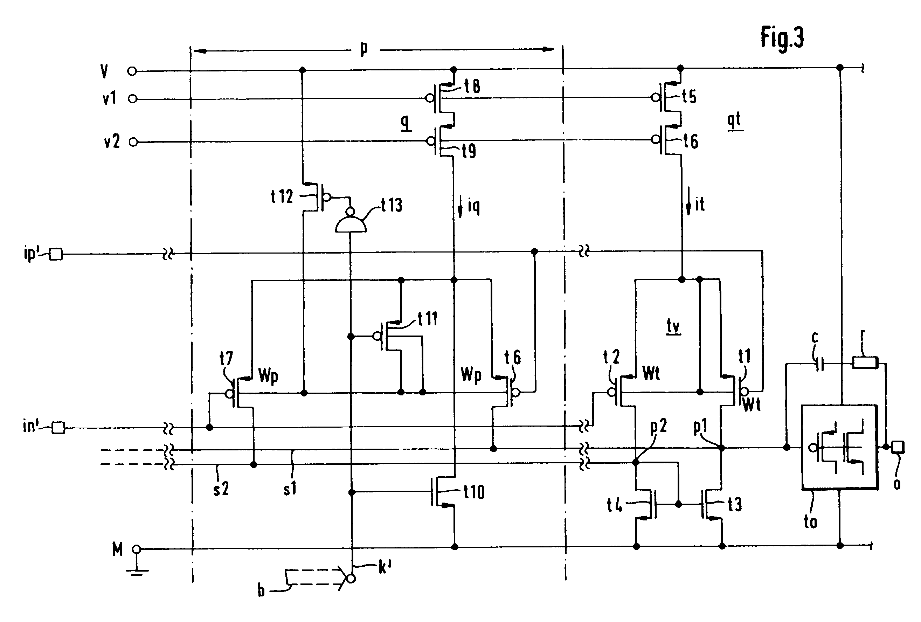

Die Einstellung unterschiedlicher Verstärkungs-Bandbreite-Produkte des adaptiven Verstärkers av ist anhand des in Fig. 3 dargestellten Schaltungsauschnittes leicht erkennbar. Der Ausschnitt betrifft ein bevorzugtes Ausführungsbeispiel des adaptiven Verstärkers in CMOS-Technik. Die Eingangsstufe besteht dabei aus einem ersten Transkonduktanzverstärker tv, dessen Differenzstufe aus einem p-Kanal-Transistorpaar t1, t2 gebildet ist, deren zusammengeschalteten Source-Anschlüsse von einem ersten Quellenstrom it aus einer ersten Stromquelle qt gespeist sind. Der Gate-Anschluß des Transistors t1 bzw. t2 bildet den nichtinvertierenden bzw. invertierenden Eingang ip', in' des adaptiven Verstärkers av. Dabei sind die Eingangsanschlüsse als lange Verbindungsleitungen ausgebildet, weil an diese Leitungen noch die Eingangsstufen einer Anzahl von Parallelschaltstufen p anzuschließen sind, von denen in Fig. 3 eine einzige als Beispiel dargestellt ist.

Im ersten Transkonduktanzverstärker tv ist der Drain-Strom des Transistors t2 auf den Eingang eines n-Kanal-Stromspiegels aus den Transistoren t4, t3 geführt, dessen Ausgang mit dem Drainanschluß des Transistors t1 den ersten Schaltungsknoten p1 bildet. Der zweite Schaltungsknoten p2 ist der Drain-Verbindungspunkt der Transistoren t2 und t4. Der erste bzw. zweite Schaltungsknoten p1, p2 ist mit einer ersten bzw. zweiten Stromschiene s1, s2 verbunden, die den beiden Schaltungsknoten zusätzlich die Drain-Ströme aus den aktivierten Parallelschaltstufen p zuführen. Der erste Schaltungsknoten p1 stellt den Ausgang des ersten Transkonduktanzverstärkers tv dar, der mit dem Eingang eines zweiten Transkonduktanzverstärkers to verbunden ist, der als Gegentakt-Ausgangstreiberstufe dient und mit der Ausgangsklemme o verbunden ist. Vorteilhafte A/B-Gegentaktausgangsstufen in CMOS-Technik sind beispielsweise in dem bereits genannten Aufsatz aus "IEEE Journal of Solid-State Circuits", Bd.SC-22, Nr. 6, Dezember 1987, Seiten 1082 bis 1089 beschrieben. Ein besonders vorteilhaftes Ausführungsbeispiel ist auch Gegenstand der europäischen Patentanmeldung EP-A- 0 460 263 (veröffentlicht 11. 12. 1991).

Zwischen der Ausgangsklemme o und dem ersten Schaltungsknoten p1 liegt ein Gegenkopplungsnetzwerk mit einem Widerstand r und einem Kondensator c in Reihenschaltung. Dieses Gegenkopplungsnetzwerk r, c in Verbindung mit dem ersten und zweiten Transkonduktanzverstärker bewirkt eine 20 dB/Dekade-Frequenzabsenkung der Leerlaufverstärkung, wenn für den späteren Betrieb eine Gegenkopplung bis zur Verstärkung 0 dB vorgesehen werden soll. Das zugehörige Verstärkungs-Bandbreite-Produkt ergibt sich aus der Dimensionierung des ersten Quellenstromes it und der Steilheit der Differenzstufe t1, t2, wobei die Kanalbreite (= Wt) und die Kanallänge (= Lt) als wesentliche Größen miteingehen.

Die Steilheit des ersten Transkonduktanzverstärkers (tv) ist änderbar, wenn die Kanalbreite Wt und der erste Quellenstrom it in gleichem Verhältnis vergrößert oder verkleinert werden. Dies wird durch die Parallelschaltstufen p ermöglicht, indem diese zu den p-Kanal-Transistoren t1, t2 der Differenzstufe möglichst gleichartige p-Kanal-Transistoren t6, t7 parallelschalten, wobei sich der erste Quellenstrom it zum zweiten Quellenstrom iq verhält wie Wt : Wp. Dabei speist der zweite Quellenstrom iq die zusammengeschalteten Source-Anschlüsse der p-Kanal-Transistoren t6, t7 in der jeweiligen Parallelschaltstufe p. Zur Erhaltung der Gleichartigkeit bleiben die Kanal längen Lt und Lp einander gleich.

Der Gate-Anschluß des p-Kanal-Transistors t6 bzw. t7 ist mit dem invertierenden bzw. nichtinvertierenden Eingang ip' bzw. in' über die bereits beschriebene lange Verbindungsleitung angeschlossen. Der Drain-Anschluß des Transistors t6 bzw. t7 ist mit dem ersten bzw. zweiten Schaltungsknoten p1 bzw. p2 über die erste bzw. zweite Stromschiene s1, s2 verbunden.

Damit die unerwünschte Erhöhung der Schwellenspannung der p-Kanal-Transistoren t1, t2 durch den üblichen Anschluß ihrer n-Wanne an das positive Versorgungspotential V vermieden wird, wird die n-Wanne an das gemeinsame Source-Potential der Transistoren t1, t2 angeschlossen. Dadurch bleibt auch die Steilheit des ersten Transkonduktanzverstärkers tv unabhängig vom Gleichpegel an den beiden Eingängen ip', in'. Aus Gründen der Gleichartigkeit müssen auch die n-Wannen der p-Kanal-Transistoren t6, t7 an deren gemeinsames Source-Potential angeschlossen werden. Dies gilt aber nur für den Fall, daß die Parallelschaltstufe p aktiviert ist. Bei abgeschalteter Parallelschaltstufe wird das Wannenpotential mittels eines p-Kanal-Transistors t12 auf den positiven Versorgungsanschluß V geschaltet. Gleichzeitig wird über einen p-Kanal-Transistor t11 die Verbindung zwischen Wannenanschluß und gemeinsamem Source-Potential aufgetrennt und schließlich mittels eines n-Kanal-Transistors t10 der Strom iq der zweiten Stromquelle q auf den Bezugsspannungsanschluß M abgeleitet. Dieser Schaltvorgang wird durch ein 1-Bit-Steuersignal k' bewirkt, das der jeweiligen Parallelschaltstufe p mittels des Datenbusses b zugeführt ist. Damit die beiden p-Kanal-Transistoren t11, t12 gegensinnig schalten, wird das 1-Bit-Steuersignal vor dem Gate-Anschluß des Transistors 12 mittels eines Inverters t13 invertiert.

Durch diese umfangreiche Schalteinrichtung in jeder Parallelschaltstufe wird für jede aktivierte Parallelschaltstufe p eine möglichst genaue Gleichartigkeit zur Differenzstufe t1, t2 erreicht. Bei den abgeschalteten Parallelschaltstufen werden die einzelnen Potentiale so umgeschaltet, daß die Auswirkung auf die Differenzstufe t1, t2 und die Stromquellen qt, q möglichst gering werden. Die Rückwirkung der abgeschalteten Parallelschaltstufen auf die gemeinsam gesteuerten Stromquellen erfolgt mittels der Stromableitung durch Transistor t10 und die Kaskodierung der Stromquellen. Die erste Stromquelle qt aus den p-Kanal-Transistoren t5, t6 ist von einer ersten bzw. zweiten Vorspannung v1, v2 gesteuert. Entsprechend hierzu ist die zweite Stromquelle q aus den kaskodierten p-Kanal-Transistoren t8, t9 gebildet.

## Patentansprüche

1. Monolitisch integrierter Differenzverstärker mit einer digital gesteuerten Verstärkungseinstellung, der in Kombination folgende Teilschaltungen enthält:
- eine erste Widerstandskette (R1) mit Abgriffen, die den Eingängen (1,..., 5) eines ersten Multiplexers (m1) zugeführt sind, dessen Ausgang am invertierenden Eingang (in') eines adaptiven Verstärkers (av) liegt,
- eine zweite Widerstandskette (R2) mit Abgriffen, die den Eingängen (1, ..., eines parallel gesteuerten zweiten Multiplexers (m2) zugeführt sind, dessen Ausgang am nichtinvertierenden Eingang (ip') des adaptiven Verstärkers (av) liegt,
- der Eingang der ersten bzw. zweiten Widerstandskette bildet den invertierenden bzw. nichtinvertierenden Eingang (in, ip) des Differenzverstärkers,
- der Ausgang der ersten bzw. zweiten Widerstandskette ist mit der Ausgangsklemme (o) des adaptiven Verstärkers (av) bzw. mit einem Bezugspotentialanschluß (M) verbunden,
- der Steuereingang des ersten und zweiten Multiplexers (m1, m2) und des adaptiven Verstärkers (av) ist an einen Datenbus (b) angeschlossen,
- der adaptive Verstärker (av) enthält Einrichtungen, die über das zugeführte Datensignal sein Verstärkungs-Bandbreiten-Produkt in Stufen umschalten, wobei das Verstärkungs-Bandbreiten-Produkt an die mit den Widerstandsketten gewählte Verstärkung angepaßt ist.

2. Differenzverstärker nach Anspruch 1, gekennzeichnet durch folgende Merkmale:
- der adaptive Verstärker (av) enthält als Eingangsstufe einen ersten Transkonduktanzverstärker (tv), als Ausgangsstufe einen zweiten Transkonduktanzverstärker (to) und ein Gegenkopplungsnetzwerk (r, c) zur Frequenzgangfestlegung, und
- der erste Transkonduktanzverstärker (tv) ist in seiner Steilheit mittels einer Zuschaltung von Parallelschaltstufen (p) in Stufen änderbar, wobei die Parallelschaltstufen gleichartig zur Differenzstufe des ersten Transkonduktanzverstärkers (tv) sind.

3. Differenzverstärker nach Anspruch 2, dadurch gekennzeichnet, daß die Schaltung in CMOS-Technik monolithisch integriert ist.

4. Differenzverstärker nach Anspruch 3, gekennzeichnet durch folgende Merkmale:
- die Differenzstufe des ersten Transkonduktanzverstärkers (tv) enthält einen ersten und einen zweiten p-Kanal-Transistor (t1, t2), deren gemeinsamer Source-Anschluß mit einem ersten Quellenstrom it gespeist ist und deren Kanalbreite Wt und Kanallänge Lt festgelegt sind,
- jede Parallelschaltstufe (p) enthält einen dritten und einen vierten p-Kanal-Transistor (t6, t7), deren gemeinsamer Source-Anschluß mit einem zweiten Quellenstrom iq gespeist ist und deren Kanalbreite Wp und Kanallänge Lp festgelegt sind,
- in jeder Parallelschaltstufe (p) ist der Quellenstrom iq, die Kanalbreite Wp und die Kanallänge Lp wie folgt festgelegt:
-- die Kanallänge Lp ist gleich wie beim ersten und zweiten p-Kanal-Transistor (t1, t2) und
-- die Kanalbreite Wp der Parallelschaltstufe (p) verhält sich zur Kanalbreite Wt des ersten und zweiten p-Kanal-Transistors (t1, t2) wie der zweite Quellenstrom iq zum ersten Quellenstrom it.

5. Differenzverstärker nach Anspruch 3 oder 4, dadurch gekennzeichnet, daß bei allen aktivierten Parallelschaltstufen (p) die jeweilige n-Wanne für den zweiten und dritten p-Kanal-Transistor (t6, t7) über Schalteinrichtungen an das jeweilige Source-Potential des zweiten und dritten p-Kanal-Transistors (t6, t7) angeschlossen ist und daß bei allen nichtaktivierten Parallelschaltstufen (p) die n-Wannen an ein hohes Versorgungspotential (V) angeschlossen sind.

6. Differenzverstärker nach Anspruch 4, dadurch gekennzeichnet, daß bei den nichtaktivierten Parallelschaltstufen (p) der zweite Quellenstrom iq auf den Bezugspotentialanschluß (M) geschaltet sind.

## Claims

1. A monolithic integrated differential amplifier with digitally controlled gain setting, comprising, in combination, the following subcircuits:
- a first resistor chain (R1) having taps connected to the inputs (1, ..., 5) of a first multiplexer (m1) whose output is coupled to the inverting input (in') of an adaptive amplifier (av);
- a second resistor chain (R2) having taps connected to the inputs (1, ..., 5) of a parallel-controlled, second multiplexer (m2) whose output is coupled to the noninverting input (ip') of the adaptive amplifier (av);
- the inputs of the first and second resistor chains form the inverting and noninverting inputs (in, ip), respectively, of the differential amplifier;
- the outputs of the first and second resistor chains are connected to the output terminal (o) of the adaptive amplifier (av) and to a reference-potential terminal (M), respectively;
- the control inputs of the first and second multiplexers (m1, m2) and of the adaptive amplifier (av) are connected to a data bus (b); and
- the adaptive amplifier (av) includes devices which switch its gain-bandwidth product in steps via the applied data signal, with the gain-bandwidth product adapted to the gain selected with the resistor chains.

2. A differential amplifier as claimed in claim 1, characterized by the following features:
- The adaptive amplifier (av) comprises a first transconductance amplifier (tv) as an input stage, a second transconductance amplifier (to) as an output stage, and a negative-feedback network (r, c) for determining the frequency response; and
- the transconductance of the first transconductance amplifier (tv) is variable in steps by means of paralleling stages (p) which are identical in design to the differential stage of the first transconductance amplifier (tv).

3. A differential amplifier as claimed in claim 2, characterized in that the circuit is integrated using CMOS technology.

4. A differential amplifier as claimed in claim 3, characterized by the following features:
- The differential stage of the first transconductance amplifier (tv) contains a first p-channel transistor (t1) and a second p-channel transistor (t2) whose common source terminal is supplied with a first source current it and whose channel width Wt and channel length Lt are fixed;
- each paralleling stage (p) contains a third p-channel transistor (t6) and a fourth p-channel transistor (t7) whose common source terminal is supplied with a second source current iq and whose channel width Wp and channel length Lp are fixed; and
- in each paralleling stage (p), the source current iq, the channel width Wp, and the channel length Lp are fixed as follows:
-- The channel length Lp is the same as in the first and second p-channel transistors (t1, t2), and
-- the ratio of the channel width Wp of the paralleling stage (p) to the channel width Wt of the first and second p-channel transistors (t1, t2) is equal to that of the second source current iq to the first source current it.

5. A differential amplifier as claimed in claim 3 or 4, characterized in that in all activated paralleling stages (p), the respective n-wells for the second and third p-channel transistors (t6, t7) are connected via switching devices to the respective source potentials of the second and third p-channel transistors (t6, t7), and that in all nonactivated paralleling stages (p), the n-wells are connected to a high supply potential (V).

6. A differential amplifier as claimed in claim 4, characterized in that in the nonactivated paralleling stages (p), the second source current iq is switched to the reference-potential terminal (M).

## Revendications

1. Amplificateur différentiel intégré monolithique, à réglage de gain à commande numérique, qui contient en combinaison les circuits partiels suivants :
- une première chaîne de résistances (R1) comportant des prises qui sont appliquées aux entrées (1, ... ,5) d'un premier multiplexeur (m1) dont la sortie est appliquée sur l'entrée inverseuse (in') d'un amplificateur adaptatif (av),
- une seconde chaîne de résistances (R2) comportant des prises qui sont appliquées aux entrées (1, ... ,5) d'un second multiplexeur (m2) commandé en parallèle dont la sortie est appliquée à l'entrée non inverseuse (ip') de l'amplificateur adaptatif (av),
- l'entrée de la première chaîne de résistances et celle de la seconde chaîne de résistances constituent respectivement l'entrée inverseuse (in) et l'entrée non inverseuse (ip) de l'amplificateur différentiel,
- la sortie de la première chaîne de résistances et celle de la seconde chaîne de résistances sont reliées respectivement à la borne de sortie (o) de l'amplificateur adaptatif (av) et à une connexion de potentiel de référence (M),
- l'entrée de commande du premier multiplexeur (m1), celle du second multiplexeur (m2) et celle de l'amplificateur adaptatif (av) sont raccordées à un bus de données (b),
- l'amplificateur adaptatif (av) contient des dispositifs qui, par l'intermédiaire du signal de données envoyé, commutent son produit bande passante-gain d'une manière étagée, le produit de bande passante-gain étant adapté au gain choisi avec les chaînes de résistances.

2. Amplificateur différentiel selon la revendication 1, caractérisé par les particularités suivantes :
- l'amplificateur adaptatif (av) contient, en tant qu'étage d'entrée, un premier amplificateur (tv) à transconductance, en tant qu'étage de sortie, un second amplificateur (to) à transconductance et un réseau de réaction (r, c) servant à la détermination de la réponse en fréquences et
- le premier amplificateur (tv) à transconductance peut faire l'objet d'une variation d'une manière étagée, en ce qui concerne sa pente, en ajoutant au circuit des étages (p) à montage parallèle, les étages à montage parallèle étant semblables à l'étage différentiel du premier amplificateur (tv) à transconductance.

3. Amplificateur différentiel selon la revendication 2, caractérisé en ce que le circuit est un circuit intégré monolithique réalisé en technique CMOS.

4. Amplificateur différentiel selon la revendication 3, caractérisé par les particularités suivantes :
- l'étage différentiel du premier amplificateur (tv) à transconductance contient un premier et un second transistors à canal P (t1, t2) à la connexion de source commune desquels un premier courant de source it est appliqué et dont la largeur de canal Wt et la longueur de canal Lt sont fixées,
- chaque étage (p) à montage parallèle contient un troisième et un quatrième transistors à canal p (t6, t7) à la connexion de source commune desquels un second courant de source iq est appliqué et dont la largeur de canal Wp et la longueur de canal Lp sont fixées,
- dans chaque étage (p) à montage parallèle, le courant de source iq, la largeur de canal Wp et la longueur de canal Lp sont fixés comme suit :
- - la longueur de canal Lp est égale à celle se présentant dans le premier et le second transistors canal p (t1, t2) et
- - la largeur de canal Wp de l'étage (p) à montage parallèle est dans le même rapport vis-à-vis de la largeur de canal Wt du premier et du second transistors à canal P (t1, t2) que le second courant de source iq vis-à-vis du premier courant de source it.

5. Amplificateur différentiel selon la revendication 3 ou 4, caractérisé en ce que, dans tous les étages (p) à montage parallèle qui sont activés, les régions N correspondant au deuxième et au troisième transistors à canal P (t6, t7) sont raccordés, par l'intermédiaire de dispositifs de circuit respectivement au potentiel de source du second transistor à canal P (t6) et à celui du troisième transistor à canal P (t7) et en ce que, dans tous les étages (p) à montage parallèle qui ne sont pas activés, les régionsN sont raccordées à un potentiel d'alimentation élevé (V).

6. Amplificateur différentiel selon la revendication 4, caractérisé en ce que, dans les étages (p) à montage parallèle qui ne sont pas activés, le second courant de source iq est connecté à la connexion de potentiel de référence (M).
